# EUROPEAN PATENT APPLICATION

(11) **EP 4 797 785 A1**
(43) Date of publication of application: **26.08.2026**
(21) Application number: 24887785.4
(22) Date of filing: 28.10.2024
(51) Int. Cl.: H04W 28/06

(54) **DATA PROCESSING METHOD AND RELATED APPARATUS**

(30) Priority: 08.11.2023 CN 202311483249
(71) Applicant: HUAWEI TECHNOLOGIES CO., LTD., Shenzhen 518129 (CN)
(72) Inventor: XIE, Junwen, Shenzhen, Guangdong 518129 (CN); MA, Mengyao, Shenzhen, Guangdong 518129 (CN); XIAO, Yao, Shenzhen, Guangdong 518129 (CN)
(74) Representative: Körber, Martin Hans
(86) International application number: PCT/CN2024/127685
(87) International publication number: WO 2025/098172

(57) **Abstract**

This application provides a data processing method and a related apparatus. In the data processing method provided in this application, sensing data obtained by a UE is classified into first target data and second target data. An object corresponding to the first target data has a corresponding projection in reconstruction space, and an object corresponding to the second target data has no corresponding projection in the reconstruction space. The first target data and the second target data are compressed in different compression modes, and are uploaded to a base station, where compression degree corresponding to the first target data is higher than a compression degree corresponding to the second target data. This reduces an amount of data exchanged with the base station, improves communication efficiency during environment reconstruction, and reduces bandwidth load.

## Description

This application claims priority to Chinese Patent Application No. 202311483249.8, filed with the China National Intellectual Property Administration on November 8, 2023 and entitled "DATA PROCESSING METHOD AND RELATED APPARATUS", which is incorporated herein by reference in its entirety.

### TECHNICAL FIELD

This application relates to the communication field, and in particular, to a data processing method and a related apparatus.

### BACKGROUND

With high-speed development of wireless communication technologies, a base station may obtain, through reconstruction based on sensing data uploaded by user equipments (user equipment, UE), information about ambient environment in which the UEs are located, to implement environment reconstruction. During real time maintenance of a reconstruction map, to ensure performance of the environment reconstruction, the base station needs to obtain a large amount of sensing data. However, upload efficiency of the UEs is not high under limited bandwidth. How to improve communication efficiency during environment reconstruction becomes a technical problem to be urgently resolved.

### SUMMARY

This application provides a data processing method and a related apparatus, to improve communication efficiency during environment reconstruction and reduce bandwidth load.

According to a first aspect, this application provides a data processing method, applied to a terminal device. The method includes: obtaining target sensing data, where the target sensing data is sensing data of a target object in first space in which the terminal device is located; compressing first target data in the target sensing data in a first compression mode, to obtain first compressed data, where the first target data is sensing data of a first target object in the first space, and reconstruction space corresponding to the first space includes a first reconstructed object corresponding to the first target object; and sending the first compressed data and first index information to a network device, where the first index information indicates that the first compressed data corresponds to the first reconstructed object.

In the method, the first target data is determined from the target sensing data based on a reconstructed object that already exists in the reconstruction space corresponding to the first space. The first target data is compressed in the first compression mode, so that a data amount required for updating the first reconstructed object can be reduced. This reduces a data amount for exchange with a base station, improves communication efficiency during environment reconstruction, and reduces bandwidth load.

In addition, because the base station uses association between the first target data and data corresponding to the first reconstructed object when updating a reconstruction map, an object in a sensing blind area of a UE may be reserved on the reconstruction map, thereby improving accuracy of the reconstruction map.

In some implementations, before the first target data in the target sensing data is compressed in the first compression mode, to obtain the first compressed data, the method further includes:
receiving first indication information from the network device, where the first indication information is used to determine the first target data; and determining the first target data from the target sensing data based on the first indication information, and obtaining the first index information based on the first indication information.

In some implementations, the method further includes:
compressing second target data in the target sensing data in a second compression mode, to obtain second compressed data, where the second target data is sensing data of a second target object in the first space, and the reconstruction space includes no second reconstructed object corresponding to the second target object; and sending the second compressed data to the network device.

In some implementations, the first compression mode includes: determining pose data corresponding to the first target data as the first compressed data, where the pose data includes location data and/or posture data.

In some implementations, the first compression mode includes: determining a difference between pose data corresponding to the first target data and first pose data as the first compressed data, where the pose data includes location data and/or posture data, and the first pose data is pose data of the first reconstructed object in the reconstruction space.

In some implementations, the location data includes geometric central point data and/or geometric vertex data, and the posture data includes yaw angle data.

The pose data of the first target object is determined as the first compressed data, so that a data amount required for updating the first reconstructed object can be minimized while reconstruction performance is ensured, thereby improving communication efficiency.

In some implementations, the first indication information includes at least one piece of target data, the at least one piece of target data is in one-to-one correspondence with at least one reconstructed object included in the reconstruction space, each of the at least one piece of target data includes pose data of a corresponding reconstructed object, and the pose data includes location data and/or posture data.

Determining the first target data from the target sensing data based on the first indication information includes:
obtaining pose data corresponding to each piece of target data in the target sensing data, where a difference between a posture indicated by posture data corresponding to the first target data and a posture indicated by posture data in third target data in the at least one piece of target data is less than a posture difference threshold, and/or a distance between location data corresponding to the first target data and location data in the third target data is less than a first distance threshold, where the third target data corresponds to the first reconstructed object.

In some implementations, the third target data further includes sampling point data of the first reconstructed object, and the sampling point data of the first reconstructed object indicates location data of each of at least one point on the first reconstructed object.

The method further includes:
determining a first neighboring distance between the first reconstructed object and the first target object based on the sampling point data included in the third target data, where the first neighboring distance indicates a shortest distance between the first reconstructed object and the first target object;
compressing fourth target data in a third compression mode, to obtain third compressed data, where the fourth target data is sensing data of a fourth target object in the first target object, the first neighboring distance corresponding to the fourth target object is greater than or equal to a second threshold, and a compression ratio of the third compression mode is higher than that of the second compression mode; and sending the third compressed data to the network device.

The first target data is further compressed in a fine-grained manner by using sampling point data, as auxiliary information, that is of a reconstructed object and that is delivered by the base station, so that accuracy of the reconstruction map is further improved while the communication efficiency is ensured, and reconstruction performance requirements can be met in different scenarios.

In some implementations, the first compressed data and the second compressed data are first sent, and the third compressed data is then sent by adding a layer.

When a quantity of uplink resources are limited, a requirement on the uplink resources may be reduced through the layered sending.

In some implementations, that the sampling point data of the first reconstructed object indicates the location data of each of the at least one point on the first reconstructed object includes:
the sampling point data of the first reconstructed object indicates location data of each of at least one point on a first outer surface of the first reconstructed object, and the first outer surface includes at least one outer surface of the first reconstructed object.

That the first neighboring distance indicates the shortest distance between the first reconstructed object and the first target object includes:
the first neighboring distance indicates a shortest distance between a first outer surface of the first target object and a second outer surface of the first reconstructed object, and the second outer surface is an outer surface that is of the first reconstructed object and that corresponds to the first outer surface of the first target object.

The first target object is further processed in a fine-grained manner based on surfaces, so that compressed data can be sent at a finer granularity, thereby improving reconstruction performance.

In some implementations, before receiving the first indication information from the network device, the method further includes:
sending first request information to the network device, where the first request information is used to request sampling point data of a reconstructed object included in the reconstruction space, where each piece of target data includes sampling point data of the corresponding reconstructed object.

For reconstruction performance requirements for different tasks, the terminal device actively requests, from the network device, the sampling point data of the reconstructed object, so that requirements for reconstruction performance and communication efficiency can be balanced for different scenarios.

In some implementations, the first indication information further indicates the second distance threshold.

In some implementations, before the first target data in the target sensing data is compressed in the first compression mode, to obtain the first compressed data, the method further includes:
sending pose data corresponding to each of a plurality of pieces of target data in the target sensing data to the network device, where the plurality of pieces of target data are in one-to-one correspondence with a plurality of target objects in the first space; and receiving the first indication information from the network device, where the first indication information indicates the first target data and the second target data in the plurality of pieces of target data.

In some implementations, the first indication information further indicates to compress the first target data in the first compression mode, and the first indication information further indicates to compress the second target data in the second compression mode.

In some implementations, before the receiving first indication information from the network device, the method further includes:
sending second request information to the network device, where the second request information is used to request sampling point data of the first reconstructed object.

In some implementations, the first compression mode includes: determining encoded residual data of the first target data and pose data corresponding to the first target data as the first compressed data, where the pose data includes location data and/or posture data.

In a single-UE time sequence scenario, the first target data and the second target data in the target sensing data may be determined based on local historical data stored by the UE, so that different compression modes can improve communication efficiency between the UE and the base station, and scenarios to which environment reconstruction is applied are expanded.

In some implementations, the method further includes:
sending third indication information to the network device, where the third indication information indicates to compress the first target data in the first compression mode and to compress the second target data in the second compression mode, and the third indication information further indicates a compression parameter of the first compression mode and a compression parameter of the second compression mode.

According to a second aspect, this application provides a data processing method, applied to a network device. The method includes:
receiving first compressed data from a terminal device, where the first compressed data is data obtained by processing first target data in a first compression mode, the first target data is sensing data of a first target object in first space, and reconstruction space corresponding to the first space includes a first reconstructed object corresponding to the first target object; and updating the reconstruction space based on the first compressed data.

In some implementations, the method further includes:
receiving second compressed data from the terminal device, where the second compressed data is data obtained through second compression processing on second target data, the second target data is sensing data of a second target object in the first space, and the reconstruction space includes no second reconstructed object corresponding to the second target object; and updating the reconstruction space based on the second compressed data.

In some implementations, the first compression mode includes: determining pose data corresponding to the first target data as the first compressed data, where the pose data includes location data and/or posture data.

In some implementations, updating the reconstruction space based on the first compressed data includes:
updating location data of each point on the first reconstructed object in the reconstruction space based on a difference between the pose data corresponding to the first target data and first pose data, where the first pose data is pose data of the first reconstructed object.

In some implementations, before the first compressed data is received from the terminal device, the method further includes:
sending first indication information to the terminal device, where the first indication information is used to determine the first target data.

In some implementations, the first indication information includes at least one piece of target data, the at least one piece of target data is in one-to-one correspondence with at least one reconstructed object included in the reconstruction space, each of the at least one piece of target data includes pose data of a corresponding reconstructed object, and the pose data includes location data and/or posture data.

In some implementations, third target data in the at least one piece of target data further includes sampling point data of the first reconstructed object, the sampling point data of the first reconstructed object indicates location data of each of at least one point on the first reconstructed object, and the third target data corresponds to the first reconstructed object.

The method further includes:
receiving third compressed data from the terminal device, where the third compressed data is data obtained by processing fourth target data in a third compression mode, the fourth target data is sensing data of a fourth target object in the first target object, the first neighboring distance corresponding to the fourth target object is greater than or equal to a second threshold, and a compression ratio of the third compression mode is higher than that of the second compression mode.

In some implementations, that the sampling point data of the first reconstructed object indicates the location data of each of the at least one point on the first reconstructed object includes:
the sampling point data of the first reconstructed object indicates location data of each of at least one point on a first outer surface of the first reconstructed object, and the first outer surface includes at least one outer surface of the first reconstructed object.

That the first neighboring distance indicates the shortest distance between the first reconstructed object and the first target object includes:
the first neighboring distance indicates a shortest distance between a first outer surface of the first target object and a second outer surface of the first reconstructed object, and the second outer surface is an outer surface that is of the first reconstructed object and that corresponds to the first outer surface of the first target object.

In some implementations, sending the first indication information to the terminal device includes:
receiving pose data corresponding to each of a plurality of pieces of target data in the target sensing data of the terminal device, where the plurality of pieces of target data are in one-to-one correspondence with a plurality of target objects in the first space; determining the first target data and the second target data from the plurality of pieces of target data, where a difference between a posture indicated by the posture data corresponding to the first target data and a posture indicated by posture data in third target data in the at least one piece of target data is less than a posture difference threshold, and/or a distance between the location data corresponding to the first target data and location data in the third target data is less than the first distance threshold, where the third target data corresponds to the first reconstructed object; and sending the first indication information to the terminal device, where the first indication information indicates the first target data and the second target data in the plurality of pieces of target data.

In some implementations, the first indication information further indicates to compress the first target data in the first compression mode, and the first indication information further indicates to compress the second target data in the second compression mode.

In some implementations, the first compression mode includes: determining encoded residual data of the first target data and pose data corresponding to the first target data as the first compressed data, where the pose data includes location data and/or posture data.

According to a third aspect, this application provides a data processing apparatus. The data processing apparatus includes functional modules configured to implement any data processing method mentioned in the foregoing implementations. Optionally, each module may be implemented by software and/or hardware.

According to a fourth aspect, this application provides a data processing apparatus, including a processor. The processor is coupled to a memory, and may be configured to execute instructions in the memory, to implement the method in any one of the possible implementations of the first aspect or the second aspect. Optionally, the apparatus further includes the memory. Optionally, the apparatus further includes a communication interface, and the processor is coupled to the communication interface.

According to a fifth aspect, this application provides a computer-readable medium. The computer-readable medium stores program code for a device to execute, and the program code includes the method in any one of the first aspect, the second aspect, or the possible implementations thereof.

According to a sixth aspect, this application provides a computer program product, including a computer program. When the computer program is executed by a processor, the method in any one of the first aspect, the second aspect, or the possible implementations thereof is implemented.

### BRIEF DESCRIPTION OF DRAWINGS

Accompanying drawings herein are incorporated into this specification and constitute a part of this specification, show embodiments in accordance with this application, and are used, together with this specification, to explain the principle of this application.
FIG. 1 is a diagram of an architecture of a communication system to which an embodiment of this application is applied;
FIG. 2 is a schematic flowchart of a data processing method according to an embodiment of this application;
FIG. 3 is a diagram of conversion on data points through rotation according to an embodiment of this application;
FIG. 4 is a schematic flowchart of a data processing method according to an embodiment of this application;
FIG. 5 is a schematic flowchart of a data processing method according to an embodiment of this application;
FIG. 6 is a schematic flowchart of a data processing method according to an embodiment of this application;
FIG. 7 is a diagram of simulation of a data processing method according to an embodiment of this application;
FIG. 8A to FIG. 8D are diagrams of simulation comparison between a data processing method according to an embodiment of this application and an existing data processing method;
FIG. 9A to FIG. 9D are diagrams of simulation comparison between a data processing method according to an embodiment of this application and an existing data processing method;
FIG. 10 is a diagram of a structure of a data processing apparatus according to an embodiment of this application;
FIG. 11 is a diagram of a structure of a data processing apparatus according to another embodiment of this application; and
FIG. 12 is a diagram of a structure of a data processing apparatus according to still another embodiment of this application.

The foregoing accompanying drawings show specific embodiments of this application, and more detailed descriptions are provided below. The accompanying drawings and text descriptions are not intended to limit the scope of the idea of this application in any mode, but are intended to describe the concept of this application to a person skilled in the art with reference to particular embodiments.

### DESCRIPTION OF EMBODIMENTS

Example embodiments are described in detail herein, and examples of the example embodiments are presented in accompanying drawings. When the following descriptions relate to the accompanying drawings, unless specified otherwise, same numbers in different accompanying drawings indicate a same or similar element. Implementations described in the following example embodiments do not represent all implementations consistent with this application. On the contrary, the implementations are merely examples of apparatuses and methods that are described in the appended claims in detail and that are consistent with some aspects of this application.

With development of wireless communication technologies, application scenarios of the wireless communication technologies have been extended to fields such as autonomous driving, virtual reality (virtual reality, VR), and augmented reality (augmented reality, AR). In the foregoing fields, a plurality of data applications such as sensing, imaging, and environment reconstruction may be implemented based on the wireless communication technologies. For example, in the environment reconstruction, a plurality of UEs may sense or observe a same environment from different perspectives and send sensing data to a network device, and the network device may obtain a complete environment map through sensing data fusion, to implement more refined environment reconstruction.

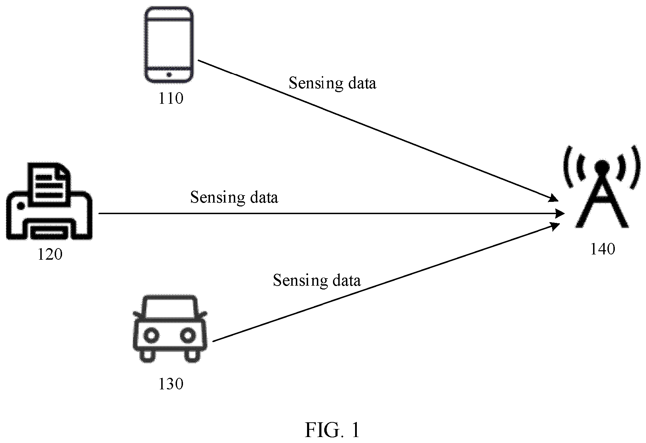

FIG. 1 is a diagram of an architecture of a communication system to which an embodiment of this application is applied. As shown in FIG. 1, the communication system includes a first communication apparatus and a second communication apparatus. The first communication apparatus may be a mobile phone 110, a printer 120, or a vehicle 130 in FIG. 1. It may be understood that in actual application, the first communication apparatus may be another sensing device. FIG. 1 is described merely by using the mobile phone, the printer, and the vehicle as an example for description.

A sensing device in this embodiment of this application may also be referred to as a terminal, is an entity, on a user side, configured to receive or transmit a signal, and is configured to send an uplink signal to a network device or receive a downlink signal from a network device. The sensing device includes a device that provides voice and/or data connectivity for a user, for example, may include a handheld device with a wireless connection function or a processing device connected to a wireless modem. The sensing device may communicate with a core network through a radio access network (wireless access network, RAN) device, and exchange a voice and/or data with the RAN. The terminal device may include a user equipment, a vehicle to wireless communication technology (vehicle to x, V2X) terminal device, a wireless terminal device, a mobile terminal device, an internet of things (internet of things, IoT) terminal device, a subscriber unit (subscriber unit), a subscriber station (subscriber station), a mobile station (mobile station), a remote station (remote station), an access point (access point, AP), a remote terminal (remote terminal), an access terminal (access terminal), a user terminal (user terminal), a user agent (user agent), a user device (user device), a wearable device, a vehicle-mounted device, an uncrewed aerial vehicle, a small cell, or the like.

The second communication device is a network device 140, or certainly may be a terminal device with a strong data processing capability. The network device 140 is a RAN device that is deployed in a radio access network and that provides a wireless communication function for the terminal device. In this embodiment of this application, the RAN device may be a device that provides a wireless communication function service, is usually located on a network side, and includes but is not limited to: a next generation base station (gNodeB, gNB) in a 5th generation (5th generation, 5G) communication system, a next generation base station in a 6th generation (6th generation, 6G) mobile communication system, a base station in a future mobile communication system, an access node in a Wi-Fi system, an evolved NodeB (evolved NodeB, eNB) in a long term evolution (long term evolution, LTE) system, a radio network controller (radio network controller, RNC), a NodeB (NodeB, NB), a base station controller (base station controller, BSC), a home base station (for example, a home evolved NodeB or a home NodeB, HNB), a baseband unit (baseband unit, BBU), a transmission reception point (transmission reception point, TRP), a transmitting point (transmitting point, TP), a base transceiver station (base transceiver station, BTS), or the like. In a network structure, the access network device may include a central unit (central unit, CU) node, a distributed unit (distributed unit, DU) node, a RAN device including a CU node and a DU node, or a RAN device including a control plane CU node, a user plane CU node, and a DU node. The radio access network device may be a macro base station, may be a micro base station, or may be a relay node or a donor node, a device that is in a V2X communication system and that provides a wireless communication service for the terminal device, a radio controller in a cloud radio access network (cloud radio access network, CRAN) scenario, a relay station, a vehicle-mounted device, a wearable device, a network device in a future evolved network, or the like. The access network device in this embodiment may alternatively be an open-radio access network (open-radio access network, O-RAN) device, and the O-RAN device may include an open-distributed unit (open-distributed unit, O-DU) and an open-central unit (open-central unit, O-CU). In this embodiment of this application, a base station function may be performed by a module (for example, a chip) in a base station, or may be performed by a control subsystem including the base station function. The control subsystem including the base station function herein may be a control center in the foregoing application scenarios such as a smart grid, industrial control, smart transportation, and a smart city. A specific technology and a specific device form that are used by the radio access network device are not limited in this embodiment of this application. For ease of description, the following uses an example in which the base station serves as the radio access network device for description.

It should also be noted that the network device 140 may include a plurality of network devices. For example, the mobile phone 110 may send a sensing result 1 to a network device 1 that serves the mobile phone 110, the printer 120 may send a sensing result 2 to a network device 2 that serves the printer 120, and the vehicle 130 may send a sensing result 3 to a network device 3 that serves the vehicle 130. Then, the network device 1 may send the sensing result 1 to the network device 140, the network device 2 may send the sensing result 2 to the network device 140, the network device 3 may send the sensing result 3 to the network device 140, and the network device 140 performs data fusion.

An objective of environment reconstruction is to obtain a reconstruction map. The reconstruction map is essentially digital virtual three-dimensional space. The virtual three-dimensional space may be used to implement digital reconstruction and reproduction of an object existing in real space. In this application, the virtual three-dimensional space is uniformly described as reconstruction space, and the reconstructed object in the reconstruction space is equivalent to a projection of a corresponding object in the real space. This meaning is used for projections mentioned below. In a real environment, an object whose location does not change over time, like a building or vegetation, is usually referred to as a background object, and correspondingly, an object whose location changes over time, like a vehicle or a pedestrian, is referred to as a foreground object.

It is clear that in comparison with the background object, the foreground object can better reflect an environment change. Therefore, during environment reconstruction, each of a plurality of UE devices periodically collects sensing data based on a perspective of the UE device. The sensing data is usually point cloud sensing data. Sensing data corresponding to the foreground object can be extracted from the sensing data by using technologies such as artificial intelligence (artificial intelligence, AI). The sensing data corresponding to the foreground object may also be referred to as target data. A location of the corresponding foreground object in this environment can be specified based on the target data.

It may be understood that the base station needs to maintain the reconstruction map in real time. The real-time maintenance herein means that when interacting with the UE device based on an update period of the reconstruction map, the base station indicates the corresponding UE device to compress and upload latest extracted target data, and the base station reconstructs, in the reconstruction space based on the target data, a projection of a foreground object corresponding to the target data, to implement the environment reconstruction.

However, each time updating the reconstruction map, the base station uses only target data received from the UE this time to reconstruct a foreground object corresponding to the target data. This means that, to ensure precision of the reconstruction map, the UE needs to compress and upload all collected target data to the base station during each update. Therefore, a large amount of data needs to be exchanged during each update, causing low communication efficiency during environment reconstruction and high bandwidth load.

To resolve the foregoing technical problem, this application provides a data processing method and a related apparatus, to improve communication efficiency during environment reconstruction and reduce bandwidth load.

A technical concept of this application is as follows: Sensing data obtained by a UE is classified into first target data and second target data. An object corresponding to the first target data has a corresponding projection in reconstruction space, and an object corresponding to the second target data has no corresponding projection in the reconstruction space. The first target data and the second target data are compressed in different compression modes, and are uploaded to a base station, where a compression degree corresponding to the first target data is higher than a compression degree corresponding to the second target data. This reduces an amount of data exchanged with the base station, improves communication efficiency during environment reconstruction, and reduces bandwidth load.

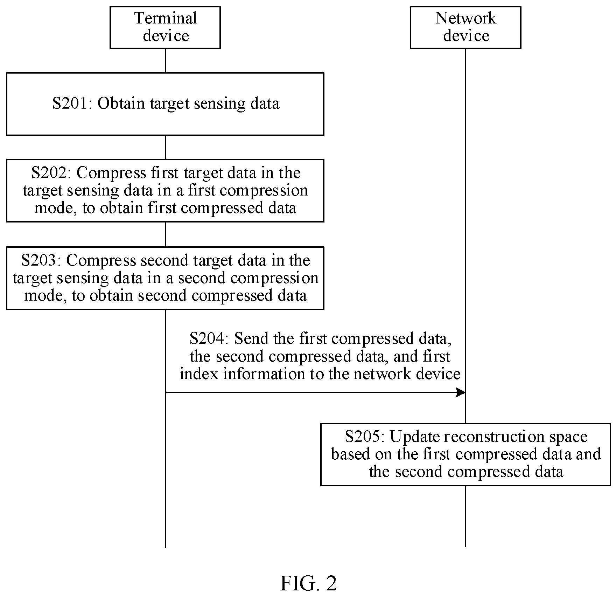

FIG. 2 is a schematic flowchart of a data processing method according to an embodiment of this application. As shown in FIG. 2, a UE in this embodiment is a UE that communicates and interacts with a base station when the base station updates a reconstruction map, and the data processing method in this embodiment includes the following steps.

S201: A terminal device obtains target sensing data.

It may be understood that a space range that can be scanned and sensed by a sensor carried on the UE device is limited. In this application, the limited space is referred to as first space. A three-dimensional Cartesian coordinate system is established by using a location of the UE as an origin. Longest distances that can be sensed by the UE on coordinate axes may constitute rectangular space, and the rectangular space is the first space. Alternatively, spherical space may be constituted based on sensing radiuses of the sensor on the UE by using a location of the UE as an origin, and the spherical space is equivalent to the first space.

In this step, the target sensing data is sensing data in the first space. When the sensor scans and senses an object in the first space, for the sensor, each object is equivalent to data aggregation of a plurality of scanning points. Therefore, data corresponding to a foreground object and data corresponding to a background object in the first space may be extracted from the target sensing data by using an extraction technology like AI.

Data corresponding to each object includes a plurality of data points, and each data point actually indicates a location distance of a scanning point on a surface of the object relative to the sensor. Some data points may constitute, via a target extraction network, frame data points indicating the object. These frames are usually presented as rectangles. Therefore, a location of the object in the first space may be determined based on frame information of the object. It should be noted that when the UE obtains the target sensing data, a coordinate system is usually established by using the UE as the origin. The location indicated by the frame information of the object is a location of the object relative to the UE, and there is a high probability that a coordinate system established by the base station on the reconstruction map is different from this coordinate system.

Therefore, before environment reconstruction, the base station needs to determine an absolute coordinate system as a global coordinate system. The global coordinate system is a coordinate system corresponding to the reconstruction map. A global geographic coordinate system indicating longitude (longitude), latitude (latitude), and altitude (altitude) may typically serve as the global coordinate system. To accurately reconstruct a projection of the object in the first space on the reconstruction map, before step S201, the UE further needs to report information about the first space to the base station. The information about the first space not only includes coordinate system information corresponding to the first space, but also includes a location, in the first space, of the sensor carried on the UE in the first space and a sensing coordinate system corresponding to the sensor.

For example, the UE is a vehicle, and the sensor is a lidar carried on the vehicle. Lidars are typically disposed at different locations of the vehicle, and are responsible for scanning and sensing information in different directions. Therefore, the information about the first space not only includes the coordinate system information corresponding to the first space, but also needs to include locations of the plurality of lidars in the first space and corresponding coordinate system information thereof.

Data corresponding to the object in the first space may be converted into the global coordinate system based on rotation matrixes and translation vectors between different coordinate systems or corresponding registration algorithms, for a subsequent operation.

It should be noted that, the UE only needs to upload the information about the first space when initially interacting with the base station, and the base station may use the initially uploaded information about the first space when subsequently updating the reconstruction map through the UE. If the information about the first space corresponding to the UE changes, for example, because the UE moves and/or the sensor carried on the UE changes a sensing radius of the sensor, a coverage area of the first space changes beyond an allowable error, the UE needs to upload changed information about the first space to the base station again.

S202: The terminal device compresses first target data in the target sensing data in a first compression mode, to obtain first compressed data.

S203: The terminal device compresses second target data in the target sensing data in a second compression mode, to obtain second compressed data.

An objective of the environment reconstruction is to reconstruct the projection of the object in the first space on the reconstruction map. Each time the base station updates the reconstruction map, received compressed data is data corresponding to a target object in the first space. Therefore, the base station actually updates a part of the reconstruction map, and the part is reconstruction space corresponding to the first space on the reconstruction map.

It may be understood that a projection of a partial object in the first space already exists in the reconstruction space corresponding to the first space. Therefore, in this application, the partial object is referred to as a first target object, and data corresponding to the first target object is the first target data. Correspondingly, a projection of the first target object in the reconstruction space corresponding to the first space is a first reconstructed object. Similarly, an object in the first space other than the first target object has no projection in the reconstruction space corresponding to the first space. Therefore, the object is referred to as a second target object, and data corresponding to the second target object is the second target data. Correspondingly, in this update of the reconstruction map, the base station obtains a projection in the reconstruction space corresponding to the first space through reconstruction based on the second target data, and the projection is equivalent to a second reconstructed object. It may be understood that the first target object and the second target object may be foreground objects in the first space.

There is no strict time sequence between steps S202 and S203. Because an update period of the reconstruction map is very short, and a location change of the first reconstructed object relative to the first target object on the reconstruction map is usually small, the base station may consider a correlation between data corresponding to the first reconstructed object and the first target data. This reduces a data amount requirement on the first target data. Therefore, in this application, the first target data is compressed in the first compression mode, to obtain the first compressed data, and the second target data is compressed in the second compression mode, to obtain the second compressed data, where a compression ratio of the first compression mode is higher than a compression ratio of the second compression mode.

It should be noted that "compression" in the conventional sense refers to a data processing method in which lossy or lossless processing is performed on a file according to an algorithm to reserve a maximum amount of file information and reduce a file size. During the environment reconstruction, the base station needs to reconstruct, based on the first target data, the first reconstructed object corresponding to the first target object in the reconstruction space corresponding to the first space. In other words, it only needs to be ensured that, the first compressed data obtained by compressing the first target data can be used to accurately reconstruct the first reconstructed object on the premise that communication efficiency during the environment reconstruction is improved. The first compression mode in this application is not limited to a conventional compression mode.

In an example, the first compression mode includes: determining pose data corresponding to the first target data as the first compressed data, where the pose data includes location data and/or posture data.

The reconstructed object on the reconstruction map needs to accurately reconstruct a location of an object in real space. It may be understood that a location occupied by the reconstructed object, for example, a vehicle, on the reconstruction map is not a simple point, but an area that can indicate an orientation of the reconstructed object. Therefore, the first compressed data can indicate location data and/or posture data of the first target object in the first space. Because pose data of the first reconstructed object in the reconstruction space corresponding to the first space is recorded on the reconstruction map of the base station, the base station may update location data and/or posture data corresponding to the first reconstructed object based on the location data and/or the posture data of the first target object, so that an updated pose corresponding to the first reconstructed object is more consistent with a pose of the first target object in the first space.

In some implementations, the first compression mode may alternatively be: determining a difference between the pose data corresponding to the first target data and first pose data as the first compressed data, where the pose data includes the location data and/or the posture data, and the first pose data is the pose data of the first reconstructed object in the reconstruction space. In this implementation, the base station may update the location data and/or the posture data corresponding to the first reconstructed object based on the difference between the location data included in the first target data and the first pose data, so that an updated pose corresponding to the first reconstructed object is more consistent with a pose of the first target object in the first space.

It can be learned from step S201 that the first target data is sensing data of the first target object, and pose information of the first target object can be obtained by calculating the first target data. In some implementations, the location data corresponding to the first target data may be geometric central point data and/or geometric vertex data of the first target object. For example, the frame is usually presented as a rectangle after AI extraction. The geometric central point data of the first target object may be centroid coordinates of a rectangle corresponding to the first target object, and the geometric vertex data of the first target object may be a plurality of vertex coordinates of the rectangle corresponding to the first target object. The posture data may be yaw angle data of the first target object, and the yaw angle data herein is an included angle between a movement direction of the first target object and a horizontal axis or a vertical axis in the global coordinate system.

It should be noted that, when the location data corresponding to the first target data is the geometric central point data of the first target object, only a location of the first reconstructed object in the reconstruction space can be determined based on the geometric central point data of the first target object, but an orientation of the first reconstructed object cannot be determined. Therefore, the first compressed data is the geometric central point data and the yaw angle data corresponding to the first target data.

Because the second reconstructed object does not exist in the reconstruction space corresponding to the first space, the base station cannot reconstruct the second reconstructed object according to a same method corresponding to the first compression mode. Therefore, a regular compression mode in a conventional technology, for example, a "Draco" compression algorithm, serves as the second compression mode.

S204: The terminal device sends the first compressed data, the second compressed data, and first index information to a network device.

The first compressed data includes a plurality of pieces of compressed data, and each piece of compressed data is in one-to-one correspondence with the first target object in the first space. Correspondingly, each piece of compressed data is also in one-to-one correspondence with the first reconstructed object. The first index information indicates that each piece of compressed data in the first compressed data is in one-to-one correspondence with the first reconstructed object. The base station may determine, in the reconstruction space corresponding to the first space based on the first index information, the first reconstructed object and sensing data corresponding to the first reconstructed object and calculate the obtained data.

In some implementations, in addition to sending the first compressed data and the second compressed data to the network device, the terminal device further needs to send third indication information to the network device. The third indication information indicates to compress the first target data in the first compression mode and to compress the second target data in the second compression mode. The third indication information further indicates a compression parameter corresponding to the first compression mode and a compression parameter corresponding to the second compression mode, for example, parameters such as quantization steps and boundaries. Based on the third indication information, the network device updates the reconstruction map by using the first compressed data and the second compressed data.

In some implementations, the terminal device and the network device may preset a unified compression solution. For example, when the received compressed data is only the geometric central point data and the yaw angle data, it may be determined that the compressed data is compressed in the first compression mode, and other compressed data is compressed according to the "Draco" algorithm. A compression parameter corresponding to the "Draco" algorithm is also a preset parameter. In this case, no indication information is needed to indicate a compression mode and a compression parameter corresponding to each piece of compressed data.

S205: The network device updates the reconstruction space based on the first compressed data and the second compressed data.

In this step, the second compressed data is data obtained through compression in a conventional compression mode. Therefore, the second compressed data is decompressed to obtain complete second target data, and the second reconstructed object can be obtained through reconstruction in the reconstruction space corresponding to the first space based on the second target data. The second reconstructed object is a projection of the second target object in the reconstruction space.

Location data of each point on the first reconstructed object may be updated based on the difference between the pose data corresponding to the first target data and the first pose data, so that the updated pose corresponding to the first reconstructed object is more consistent with the pose of the first target object in the first space.

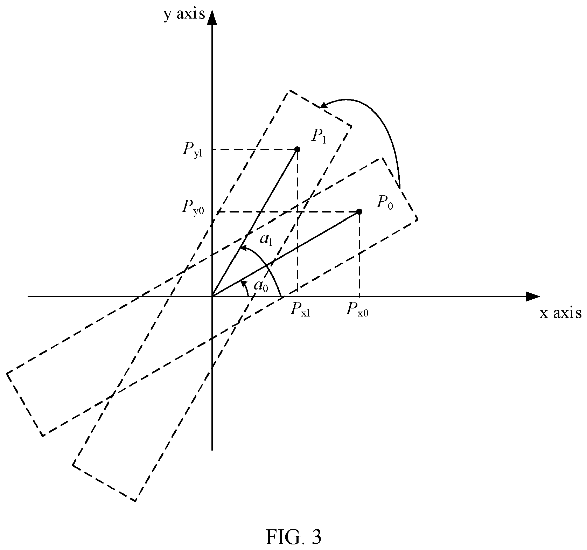

For example, the base station may learn, based on the first compressed data, that coordinates of a geometric central point of the first target object corresponding to the first target data are *s*₁, and a yaw angle of the first target object is *a*₁; and coordinates of a geometric central point of the first reconstructed object are *s*₀, and a yaw angle of the first reconstructed object is *a*₀. FIG. 3 is a diagram of conversion on data points through rotation according to an embodiment of this application. As shown in FIG. 3, the base station may rotate each data point on the first reconstructed object by an angle of *a*₁-*a*₀. Plane coordinates of a data point *p*₀ on the first reconstructed object are (*p*ₓ₀, *p*_{y0}), and new plane coordinates *p*₁ being (*p*ₓ₁, *p*_{y1}) is obtained by rotating the data point by the angle of *a*₁-*a*₀. *p*ₓ₁ = r ∗ cos(*a*₁) and *p*_{y1} = r ∗ sin(*a*₁). r is a distance from the data point to the geometric central point of the first reconstructed object, and $r = \sqrt{{{p}_{x 0}}^{2} + {{p}_{y 0}}^{2}}$. A location corresponding to the data point can be obtained by translating the coordinates obtained through rotation by a distance of *s*₁ - *s*₀. The foregoing operations are performed on each data point on the first reconstructed object, so that location data of each point on the first reconstructed object can be updated.

The first reconstructed object and a second reconstructed object are obtained through reconstruction based on the foregoing operations, thereby updating the reconstruction space.

In this embodiment, the first target data and the second target data are compressed in different compression modes, and are uploaded to the base station, thereby minimizing a data amount required for updating the first reconstructed object. This reduces an amount of data exchanged with the base station, improves communication efficiency during the environment reconstruction, and reduces bandwidth load. In addition, because the base station uses association between the first target data and data corresponding to the first reconstructed object when updating the reconstruction map, an object in a sensing blind area of the UE may be reserved on the reconstruction map, thereby improving accuracy of the reconstruction map.

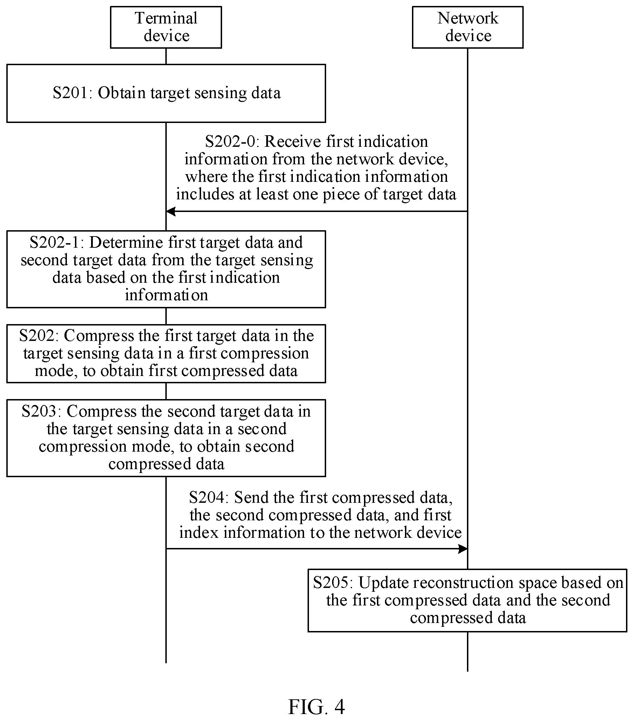

In the embodiment shown in FIG. 2, the UE needs to use different compression modes for the first target data and the second target data. Therefore, the UE first needs to distinguish between the first target data and the second target data in the target sensing data. The following describes a method in which the UE distinguishes between the first target data and the second target data. FIG. 4 is a schematic flowchart of a data processing method according to an embodiment of this application. In a possible implementation, as shown in FIG. 4, before step S202, the data processing method provided in this embodiment further includes steps S202-0 and S202-1.

S202-0: A terminal device receives first indication information from a network device, where the first indication information includes at least one piece of target data, the at least one piece of target data is in one-to-one correspondence with at least one reconstructed object included in reconstruction space, each of the at least one piece of target data includes pose data of a corresponding reconstructed object, and the pose data includes location data and/or posture data.

In this step, a base station delivers the first indication information to the UE, where the first indication information includes pose data of a reconstructed object in the reconstruction space corresponding to first space, and the pose data includes location data and/or posture data. It should be noted that, because there is a blind area in a scanning and sensing range of the UE, the pose data that is of the reconstructed object in the reconstruction space and that is indicated by the first indication information not only includes pose data of a first reconstructed object, but also includes pose data of a reconstructed object in a sensing blind area of the UE, where data corresponding to the first reconstructed object is equivalent to third target data.

It can be learned from the embodiment shown in FIG. 2 that each reconstructed object on a reconstruction map is actually aggregation of a plurality of data points, the plurality of data points are equivalent to complete data of the reconstructed object, and the base station stores complete data of each reconstructed object on the reconstruction map. Because the reconstructed object is an object obtained through reconstruction by the base station based on target sensing data uploaded by the UE, when location data corresponding to first target data uploaded by the UE is geometric center data and/or geometric vertex data of the first target object, the location data corresponding to the reconstructed object includes geometric center data and/or geometric top/bottom data of the reconstructed object. Similarly, when posture data corresponding to the first target data uploaded by the UE is yaw angle data of the first target object, the posture data corresponding to the reconstructed object includes yaw angle data.

Correspondingly, in a possible implementation, the location data that is of the reconstructed object and that is included in the first indication information is the geometric central point data and/or the geometric vertex data of the reconstructed object, and the posture data that is of the reconstructed object and that is included in the first indication information is the yaw angle data of the reconstructed object.

It should be noted that when the location data in the first indication information is the geometric central point data of the reconstructed object, only a location of the reconstructed object in the reconstruction space can be determined based on the geometric central point data of the reconstructed object, but an orientation of the reconstructed object cannot be determined. Therefore, the first indication information needs to include the geometric central point data and the yaw angle data of the reconstructed object.

When the location data in the first indication information is the geometric vertex data of the reconstructed object, because an illustrative frame of the reconstructed object is a rectangle, the geometric central point data and the yaw angle data of the reconstructed object may be further determined based on a shape characteristic of the rectangle. Therefore, the first indication information may include only the geometric vertex data of the reconstructed object.

In some implementations, if downlink resources for communication and interaction between the base station and the UE are sufficient, the base station may also deliver complete data of all reconstructed objects in the reconstruction space to the UE based on the first indication information.

S202-1: The terminal device determines the first target data and second target data from the target sensing data based on the first indication information.

It should be noted that because an update period of the reconstruction map is very short, and a distance between a location of the first target object in the first space and a location of the first reconstructed object in the reconstruction space corresponding to the first space is very short, the UE first calculates, based on the target sensing data, pose data corresponding to each of a plurality of pieces of target data, compares, with proximity pose data obtained through calculation, the pose data included in the first indication information, to determine the first target data and the second target data from the target sensing data.

In an example, coordinates of a geometric central point of a reconstructed object 1 in the reconstruction space are *s*₀, the coordinates are coordinates in a global coordinate system, and a yaw angle of the reconstructed object 1 is *a*₀. It can be learned through calculation of the target sensing data that coordinates of a geometric central point of a foreground object 2 near the coordinates *s*₀ of the first space are *s*₁, and a yaw angle of the foreground object 2 is *a*₁. In comparison of the yaw angle *a*₁ of the foreground object 2 with the yaw angle *a*₀ of the reconstructed object 1, if a value of *a*₁ - *a*₀ is less than a yaw angle threshold Δ*a*, it indicates that a movement direction of the foreground object 2 is consistent with a movement direction of the reconstructed object 1, where the yaw angle threshold is equivalent to a posture difference threshold. On the basis of determining that the movement directions are consistent, the geometric central point *s*₁ of the foreground object 2 and the geometric central point *s*₀ of the reconstructed object 1 are further calculated. If a value of *s*₁ - *s*₀ is less than a first distance threshold *T*₁, it may be determined that the foreground object 2 is the first target object in the first space, and sensing data corresponding to the foreground object 2 is the first target data in the target sensing data.

In some implementations, the first indication information may further indicate some geometric vertex coordinates and yaw angles of the reconstructed object 1 in the reconstruction space, and the geometric vertex coordinates are also coordinates in the global coordinate system. A foreground object 2 exists near geometric vertex coordinates corresponding to the first space. In comparison of a yaw angle of the foreground object 2 with the yaw angle of the reconstructed object 1, if a difference between the yaw angle of the foreground object 2 and the yaw angle of the reconstructed object 1 is less than the yaw angle threshold Δ*a*, it indicates that a movement direction of the foreground object 2 is consistent with the movement direction of the reconstructed object 1. On the basis of determining that the movement directions are consistent, a head frame and a tail frame of an object may be defined. The head frame is a frame on a same side as a movement direction that a geometric central point of the object points to, and the tail frame is a frame on a side different from the movement direction that the geometric central point of the object points to. If there is an intersection between a tail frame of the foreground object 2 and a head frame of the reconstructed object 1, it may be determined that the foreground object 2 is the first target object in the first space, and sensing data corresponding to the foreground object 2 is the first target data in the target sensing data. It may be understood that determining whether there is an intersection between frames is actually a variant method for determining a difference between geometric central points through calculation.

It is clear that in the foregoing implementations, when pose calculation between the foreground object and the reconstructed object does not meet a preset determining condition, it may be determined that the foreground object is a second target object in the first space, and sensing data corresponding to the foreground object is the second target data in the target sensing data.

In the foregoing embodiment, the base station can obtain pose data of the first target object only based on first compressed data sent by the UE, to update the first reconstructed object in the reconstruction space. However, to meet a performance requirement on the reconstruction map or a performance requirement on a specific task like obstacle avoidance, accuracy of the reconstruction map needs to be improved while communication efficiency is improved. The following describes how to improve reconstruction performance on the basis of the embodiment shown in FIG. 4.

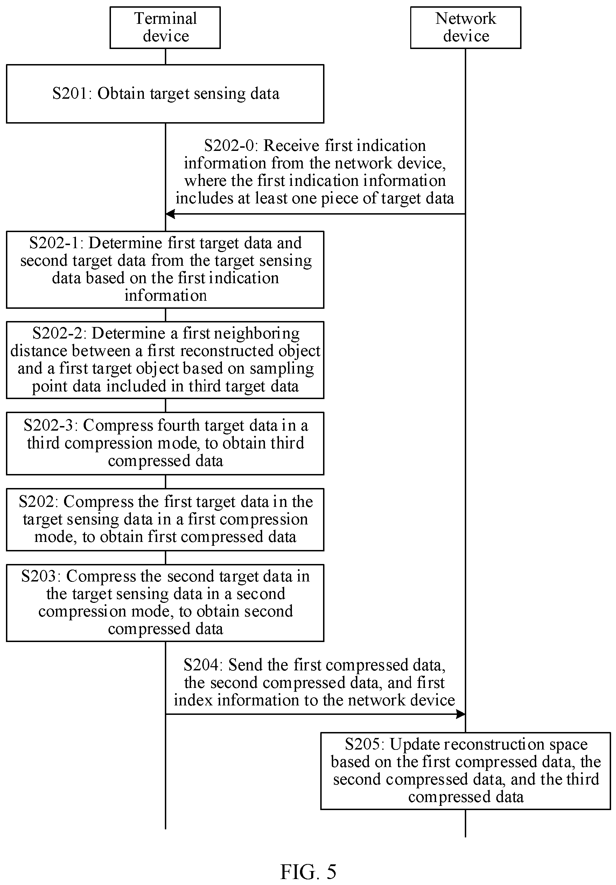

FIG. 5 is a schematic flowchart of a data processing method according to an embodiment of this application. As shown in FIG. 5, in step S202-0, third target information that is in first indication information and that is sent by a base station to a UE further includes a small amount of sampling point data of a first reconstructed object. The sampling point data is equivalent to auxiliary information, which may be for further processing first target data in a fine-grained manner. Therefore, this embodiment further needs to include steps S202-2 and S202-3.

S202-2: A terminal device determines a first neighboring distance between the first reconstructed object and a first target object based on the sampling point data included in the third target data, where the first neighboring distance indicates a shortest distance between the first reconstructed object and the first target object.

It can be learned from step S202-0 that the first reconstructed object is actually aggregation of a plurality of data points. 2% to 5% of the plurality of data points are usually selected as sampling point data. Rotation and translation are performed on each piece of sampling point data in the mode shown in FIG. 3 based on geometric central point data and yaw angle data corresponding to the first target data, to obtain updated sampling point data. The first target data, as sensing data of the first target object, also includes a plurality of data points. A distance between each of a plurality of updated sampling points and each of the plurality of data points in the first target data may be calculated. A shortest distance between each updated sampling point and each of the data points in the first target data may be obtained through calculation. An average value of a plurality of obtained shortest distances to the plurality of updated sampling points is calculated, where the average value is the first neighboring distance between the first reconstructed object and the first target object. The first neighboring distance indicates the shortest distance between the first reconstructed object and the first target object.

For example, the sampling point data of the first reconstructed object includes five sampling points, and the first target data includes 100 data points. Rotation and translation are performed on the five sampling points based on the geometric central point data and the yaw angle data corresponding to the first target data, to obtain five updated sampling points. A distance between each of the five updated sampling points and each of the 100 data points is calculated, until a shortest distance between each sampling point and each of the data points in the first target data is determined. Five shortest distances to the five updated sampling points may be obtained, and an average value of the five shortest distances is calculated, where the average value is the first neighboring distance between the first reconstructed object and the first target object in this step. The first neighboring distance can indicate the shortest distance between the first reconstructed object and the first target object.

S202-3: Compress fourth target data in a third compression mode, to obtain third compressed data.

The first target object may be further fine-grained based on the first neighboring distance obtained in step S202-2. If a first neighboring distance corresponding to a first target object 1 is not greater than a second distance threshold *T*₂, first target data corresponding to the first target object 1 is compressed in a first compression mode, to obtain first compressed data.

If a first neighboring distance corresponding to a first target object 2 is greater than the distance threshold *T*₂, the first target object 2 is not only the first target object, but also equivalent to a fourth target object in the first target object, and a first neighboring distance corresponding to the fourth target object is greater than the distance threshold *T*₂. For the first target object 2, pose data corresponding to the first target object 2 is first determined as the first compressed data, and the fourth target data is compressed in the third compression mode, to obtain the third compressed data. The fourth target data is sensing data corresponding to the first target object 2, that is, first target data corresponding to the first target object 2.

It may be understood that, after step S202-3 is performed, the UE further needs to send the third compressed data to a network device in step S204 shown in FIG. 5. To ensure communication efficiency, a compression ratio of the third compression mode is higher than that of the second compression mode. The first compressed data, second compressed data, and the third compressed data may be directly sent to the base station. In some implementations, if uplink resources for communication between the UE and the base station are limited, the UE may select layered incremental transmission, to be specific, first send the first compressed data and the second compressed data to the base station, and then send the third compressed data by adding a layer.

In addition, for the first target object 2, the base station not only receives the first compressed data corresponding to the first target object 2, but also receives the third compressed data corresponding to the first target object 2. Therefore, in step S205 shown in FIG. 5, the base station needs to perform fusion based on the first compressed data and the third compressed data corresponding to the first target object 2, to update a first reconstructed object corresponding to the first target object 2.

In some implementations, before step S202-0, the UE may send first request information to the base station based on a performance requirement on a reconstruction map or a performance requirement on a specific task, where the first request information is used to request sampling point data of all reconstructed objects included in reconstruction space. In addition, the first request information may further carry compression level information. The compression level information indicates a requirement on a compression degree. A lower compression degree requirement indicates more information that needs to be reserved in compressed data and a higher performance requirement on the reconstruction map. The base station may determine, based on the compression level information carried in the first request information, whether to deliver the sampling point data of all the reconstructed objects in the reconstruction space. It may be understood that the second distance threshold *T*₂ may be set by the base station based on the performance requirement, or may be set by the UE.

It should be noted that, for a regular object like a vehicle, sensing data of the vehicle can actually indicate outer surfaces of the vehicle in different directions except a bottom surface close to the ground. Therefore, in some implementations, the sampling point data of the first reconstructed object in step S202-2 may be sampling point data indicating a first outer surface of the first reconstructed object, and the first outer surface includes at least one outer surface of the first reconstructed object, to be specific, the sampling point data of the first reconstructed object may indicate sampling point data of different outer surfaces of the first reconstructed object. Correspondingly, when the first neighboring distance between the first reconstructed object and the first target object is calculated, a first neighboring distance between the first outer surface of the first reconstructed object and a second outer surface of the first target object needs to be calculated, where the second outer surface of the first target object and the first outer surface of the first reconstructed object are outer surfaces in one-to-one correspondence. In this implementation, first neighboring distances may be calculated respectively for different outer surfaces. For first target data corresponding to the outer surfaces, it may be separately determined whether the third compression mode needs to be used. The first target object is further processed in a fine-grained manner based on surfaces, so that the compressed data can be sent at a finer granularity, thereby improving reconstruction quality.

In this application, the first target data is further compressed in a fine-grained manner by using the sampling point data, as the auxiliary information, that is of the reconstructed object and that is delivered by the base station, so that accuracy of the reconstruction map is further improved while the communication efficiency is ensured, and high reconstruction performance requirements are met in different scenarios.

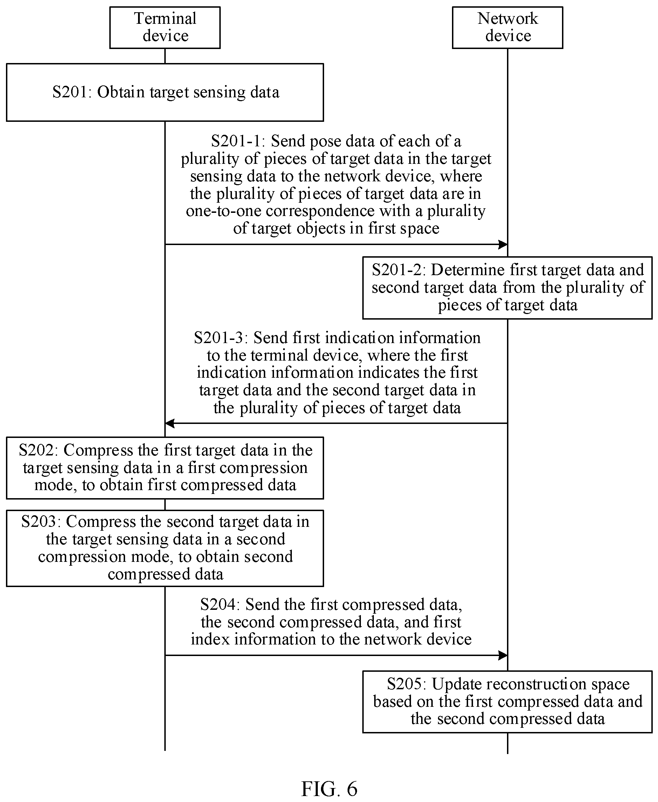

In the foregoing embodiment, the UE needs to determine the first target data and second target data from target sensing data based on the first indication information delivered by the base station. In some implementations, the base station may determine the first target data and the second target data from the target sensing data. FIG. 6 is a schematic flowchart of a data processing method according to an embodiment of this application. As shown in FIG. 6, on the basis of the embodiment shown in FIG. 2, before step S202, the data processing method provided in this embodiment further includes steps S201-1, S201-2, and S201-3. Details are as follows.

S201-1: The terminal device sends pose data corresponding to each of a plurality of pieces of target data in the target sensing data to the network device, where the plurality of pieces of target data are in one-to-one correspondence with a plurality of target objects in the first space.

In this step, the UE sends the pose data corresponding to each of the plurality of pieces of target data in the target sensing data to the base station, where each piece of target data is sensing data of a corresponding object in the first space, and the pose data corresponding to each piece of target data includes location data and/or posture data.

In some implementations, the location data corresponding to each piece of target data is geometric central point data and/or geometric vertex data of a corresponding object in the first space, and the posture data corresponding to each piece of target data is yaw angle data of the corresponding object in the first space.

When the location data corresponding to the target data is the geometric central point data of the corresponding object in the first space, only a location of a reconstructed object corresponding to the object in the reconstruction space can be determined based on the geometric central point data of the object, but an orientation of the reconstructed object cannot be determined. Therefore, the pose data corresponding to each piece of target data includes the geometric central point data and the yaw angle data.

When the location data corresponding to the target data is the geometric vertex data of the corresponding object in the first space, because an illustrative frame of the object is a rectangle, the geometric central point data and the yaw angle data of the object may be further determined based on a shape characteristic of the rectangle. Therefore, the pose data corresponding to each piece of target data may include only the geometric vertex data of the corresponding object.

S201-2: The network device determines the first target data and the second target data from the plurality of pieces of target data.

This step is similar to step S202-1 in the embodiment shown in FIG. 4, and a difference lies in that, in step S202-1, the UE determines the first target data and the second target data from the target sensing data, and in this step, the base station determines the first target data and the second target data from the target sensing data. A specific determining method is consistent with step S202-1. Details are not described herein again.

S201-3: Send first indication information to the terminal device, where the first indication information indicates the first target data and the second target data in the plurality of pieces of target data.

In step S201-2, the base station has determined the first target data and the second target data from the plurality of pieces of target data, and sends the foregoing distinguishing information to the UE via the first indication information, so that the UE can compress the first target data and the second target data by selecting different compression modes.

In some implementations, the first indication information may further directly indicate to compress the first target data in the first compression mode, and to compress the second target data in the second compression mode. The UE may directly compress the first target data and the second target data based on the first indication information.

It should be noted that, that the base station can determine the first target data and the second target data from the plurality of pieces of target data means that the base station can determine the first reconstructed object from all reconstructed objects in the first space. Therefore, the UE may send second request information to the base station based on a performance requirement on the reconstruction map or a performance requirement on a specific task, where the second request information is used to request sampling point data of the first reconstructed object in the reconstruction space. In the embodiment shown in FIG. 6, after the base station delivers the sampling point data of the first reconstructed object, the UE may further process the first target data in a fine-grained manner by using the sampling point data based on steps in the embodiment shown in FIG. 5.

In the foregoing embodiment, there are a plurality of UEs during environment reconstruction, and the base station updates the reconstruction map through fusion of data of the plurality of UEs. The data processing method provided in this application is also applicable to a single-UE time sequence scenario.

In step S201 in the embodiment shown in FIG. 2, the UE obtains the target sensing data. Because the UE periodically collects sensing data, the target sensing data is sensing data collected by the UE last time. In the foregoing embodiment, when the first target data and the second target data in the target sensing data are determined, data corresponding to a reconstructed object in the reconstruction space is needed. It may be understood that, in a single-UE scenario, before the base station updates the reconstruction map, the data corresponding to the reconstructed object in the reconstruction space is essentially data collected and uploaded by the UE in a previous collection period.

Therefore, for a single UE, the UE may obtain locally stored target sensing data collected in the previous collection period, and the UE can determine, based on the target sensing data in the previous collection period, the first target data and the second target data from target sensing data collected in this collection period. It should be noted that, because the target sensing data collected in the previous collection period is complete sensing data indicating the first target object and the second target object in the first space, the UE may further design residual encoding for the target sensing data collected in this collection period. The residual encoding herein refers to: For each data point in first target data collected in the previous collection period, a neighboring point with a shortest distance is searched for in first target data collected in this collection period, a residual between each data point in the first target data in the previous collection period and a neighboring point corresponding to the data point is calculated, and quantization encoding is performed on the residual. Because the residual is smaller than a range indicated by a complete sensing value, a used quantization parameter is smaller, and a data capacity of the obtained residual encoding is smaller. Therefore, encoded residual data of the first target data collected in the previous collection period and pose data corresponding to the first target data may be determined as first compressed data.

It may be understood that, in step S205, because the data corresponding to the reconstructed object in the reconstruction space is the data collected and uploaded by the UE in the previous collection period, a first reconstructed object corresponding to the first target data may be updated based on the encoded residual data in the first compressed data. A method for updating a second reconstructed object is consistent with that in the foregoing embodiment.

In this embodiment, in the single-UE time sequence scenario, the first target data and the second target data in the target sensing data may be determined based on local historical data stored by the UE. The data processing method provided in this application can also improve communication efficiency between the UE and the base station, and scenarios to which the environment reconstruction is applied are expanded.

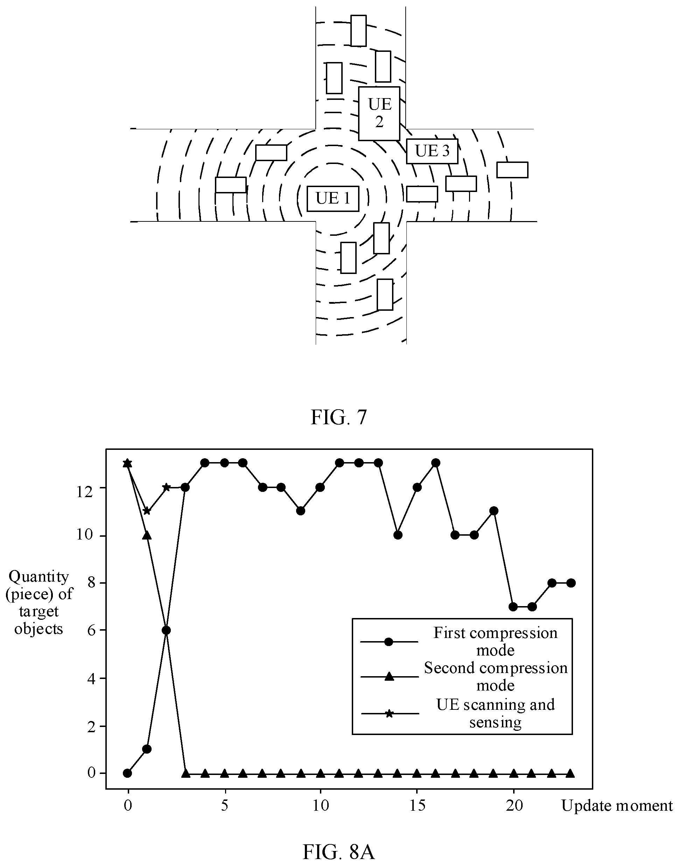

FIG. 7 is a diagram of simulation of a data processing method according to an embodiment of this application. As shown in FIG. 7, there are 14 target objects in this environment, and three of the 14 target objects are mobile UEs. When a base station updates a reconstruction map corresponding to the environment, the base station alternately interacts with the three mobile UEs. This update undergoes 24 update moments. The following compares a difference between the data processing method provided in this application and an existing data processing method in terms of a communication data amount.

FIG. 8A to FIG. 8D are diagrams of simulation comparison between a data processing method according to an embodiment of this application and an existing data processing method. In this environment, a movement speed of a UE 1 is 5 m/s (meters/second), and movement speeds of a UE 2 and a UE 3 are 7 m/s. Different UEs are opposite or vertical to each other in terms of locations. In this simulation, a UE scanning and sensing period is 0.3s.

In the existing data processing method, a UE directly performs "Draco" compression on sensing data corresponding to a scanned and sensed target object, and a compression parameter "qp" corresponding to the sensing data is 3 to 5. Larger "qp" indicates a lower compression degree of the sensing data and correspondingly, better reconstruction performance during environment reconstruction. Similarly, smaller "qp" indicates a higher compression degree of the sensing data and correspondingly, poorer reconstruction performance during environment reconstruction. According to the data processing method provided in this application, geometric central point data and yaw angle data in first target data are determined as first compressed data. "Draco" compression is also performed on second target data, and a corresponding compression parameter "qp" is 3.

As shown in FIG. 8A, a horizontal coordinate indicates an update moment, a vertical coordinate indicates a quantity of target objects, and a 0^{th} moment is equivalent to an initial moment. In this case, all target objects in first space are second target objects. It may be understood that the UE excludes the UE when obtaining target sensing data. Therefore, there are 13 second target objects in the first space at the initial moment, all target sensing data obtained by the UE is second target data, and sensing data corresponding to the 13 target objects needs to be compressed in a second compression mode. As time goes by, the base station updates the reconstruction map, and the second target object is projected in reconstruction space to obtain a second reconstructed object. At a next update moment, a part of the target objects in the first space changes from the second target object to a first target object, and correspondingly, target data in the target sensing data obtained by the UE changes from the second target data to the first target data. It can be learned from FIG. 8A that, at a 3^{rd} moment, all the target objects in the environment have been reconstructed in the reconstruction space. Therefore, at subsequent moments, the UE compresses all target data other than that of the UE in a first compression mode. Considering that there is a blind area in a scanning and sensing range of the UE, a quantity of scanned and sensed target objects in the figure changes over time.

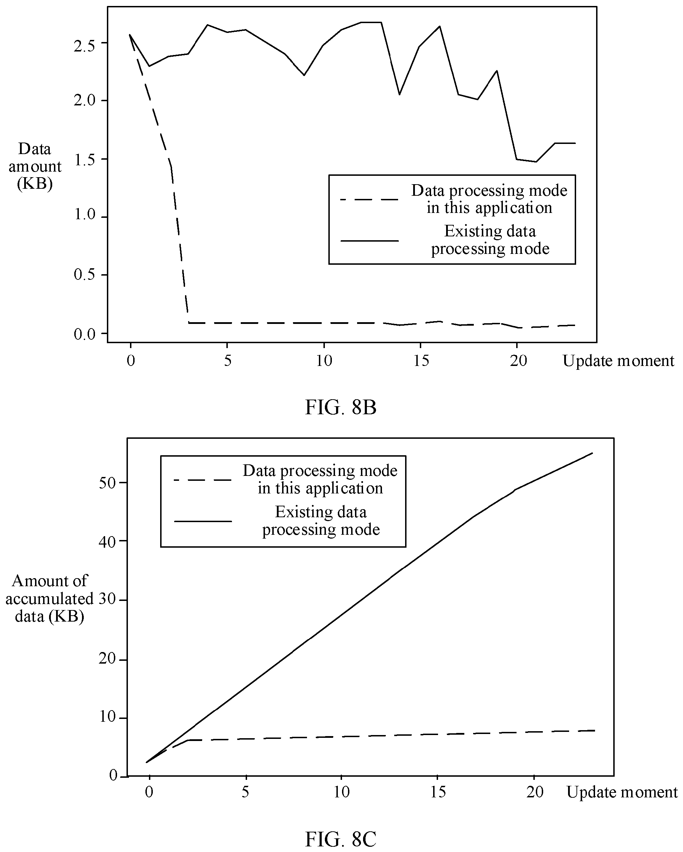

As shown in FIG. 8B, a horizontal coordinate indicates an update moment, and a vertical coordinate indicates an amount of data sent in kilobytes (kilobytes, KB) for each update. Because after a 3^{rd} moment, the UE compresses all target data other than that of the UE in a first compression mode, it can be learned from FIG. 8B that the UE needs to transmit only a very small data amount after the 3^{rd} moment. While for the existing data processing mode, because data corresponding to each target object needs to be compressed and uploaded, an amount of data that needs to be transmitted for each update is affected by the quantity of target objects scanned and sensed by the UE.

As shown in FIG. 8C, a horizontal coordinate indicates an update moment, and a vertical coordinate indicates an amount of accumulated data sent in KB. Because after a 3^{rd} moment, the UE compresses all target data other than that of the UE in a first compression mode, it can be learned from FIG. 8C that a line slope after the 3^{rd} moment is far less than those at first three moments. For the existing data processing mode, an amount of data that needs to be transmitted for each update changes slightly. Therefore, the amount of accumulated data sent increases steadily, and a line slope corresponding to the amount of accumulated data sent changes slightly. Until a last update moment, in comparison with the existing data processing method, the data processing method provided in this application can reduce the amount of accumulated data by about 85%.

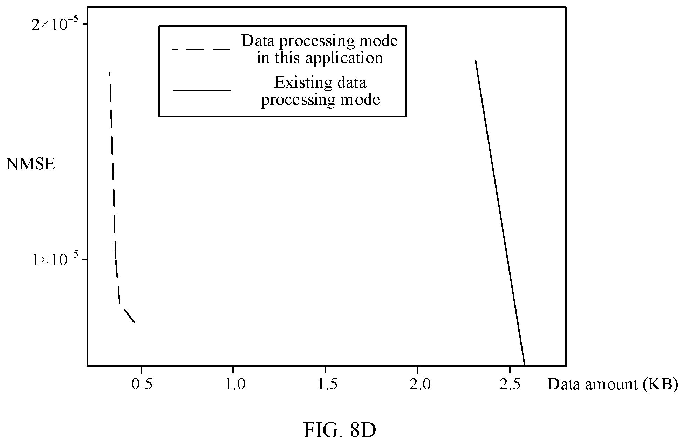

As shown in FIG. 8D, a horizontal coordinate indicates an amount of sent data, and a vertical coordinate indicates a normalized mean square error (normalized mean square error, NMSE), where the NMSE may indicate reconstruction performance. It can be learned from the figure that when the NMSE has reconstruction performance of a magnitude of 10⁻⁵, in comparison with the existing data processing method, the data processing method provided in this application can reduce the data amount by 80% to 86%. Because the base station further needs to deliver first indication information to the UE, average downlink overheads required by the first indication information is 0.086 KB, which accounts for about 20% of compressed uplink data, and accounts for about 3.6% of compressed uplink data in the existing data processing method in comparison with the existing data processing method.

It should be noted that, the reconstruction performance during environment reconstruction is related to a target distance scanned and sensed by the UE. In this simulation, the target distance is long, and collection points are sparse, affecting the reconstruction performance to some extent.

In the embodiment shown in FIG. 8A to FIG. 8D, the base station does not deliver sampling point data of a reconstructed object. The following describes how simulation comparison of further fine-grained processing is implemented based on the sampling point data.

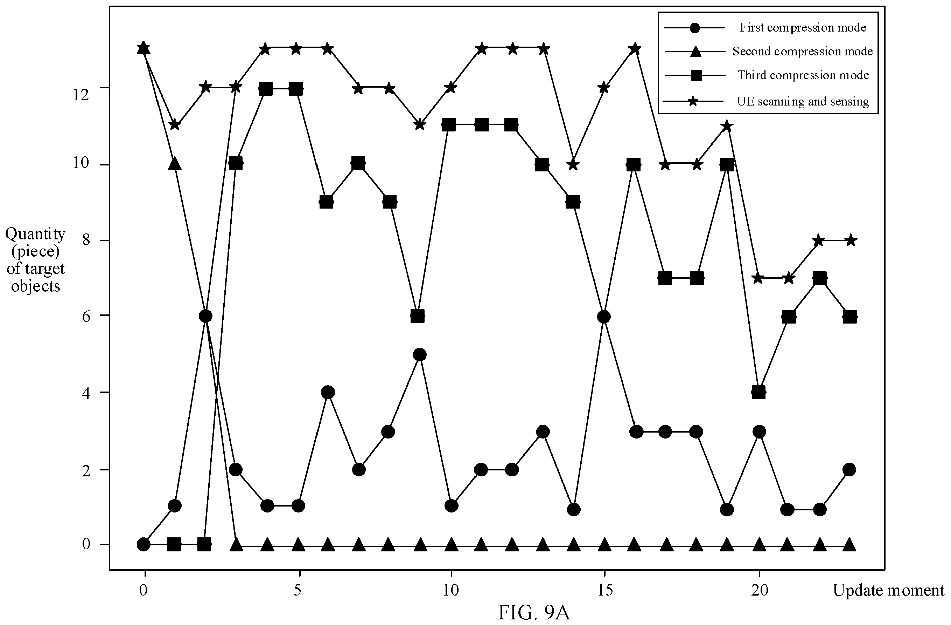

FIG. 9A to FIG. 9D are diagrams of simulation comparison between a data processing method according to an embodiment of this application and an existing data processing method. In this environment, movement speeds of the three mobile UEs and scanning and sensing periods remain unchanged. In the existing data processing method, a UE directly performs "Draco" compression on sensing data corresponding to a scanned and sensed target object, and a compression parameter "qp" corresponding to the sensing data is 4 to 8.

In this simulation, "Draco" compression is also performed on second target data, and a corresponding compression parameter "qp" is 4 to 8. The base station provides 2% to 5% sampling point data of a reconstructed object, further processes first target data in a fine-grained manner by using the sampling point data of the reconstructed object, determines geometric central point data and yaw angle data in the first target data as first compressed data, and performs "Draco" compression on fourth target data, where a compression parameter "qp" corresponding to the fourth target data is dynamically selected from 3 to 7 based on a calculation result of the sampling point data.

As shown in FIG. 9A, a horizontal coordinate indicates an update moment, and a vertical coordinate indicates a quantity of target objects. This figure is similar to FIG. 8A. In this embodiment, the sampling point data serves as auxiliary information, and the fourth target data needs to be compressed in a third compression mode. It should be noted that a target object corresponding to the fourth target data is a fourth target object. In FIG. 9A, the fourth target object is distinguished from another first target object. In the figure, the fourth target object belongs to the third compression mode, and another object in a first target object belongs to a first compression mode.

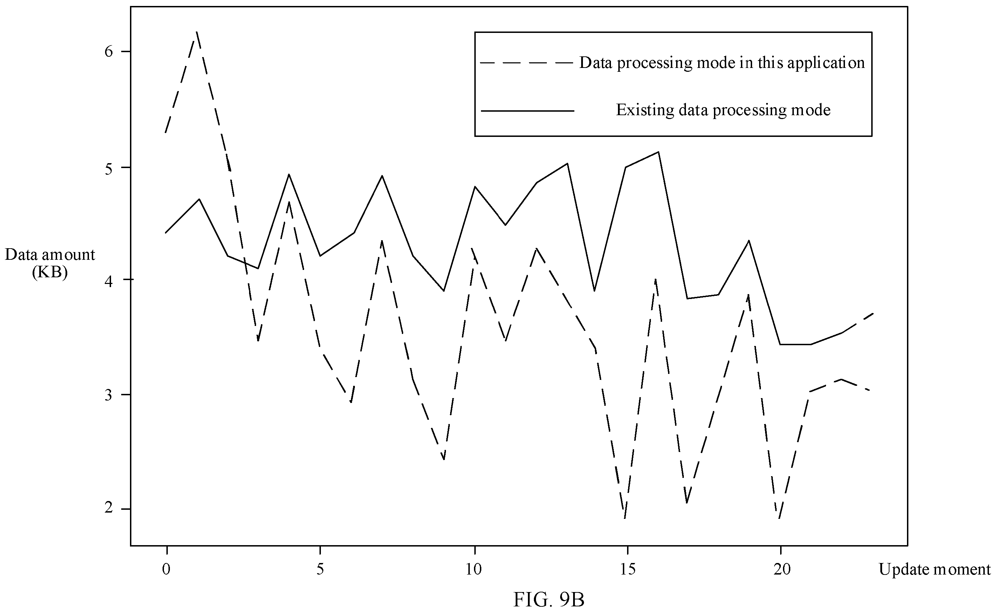

As shown in FIG. 9B, a horizontal coordinate indicates an update moment, and a vertical coordinate indicates an amount of data sent in KB for each update. Because "Draco" compression is also performed on the fourth target data, but the compression parameter "qp" corresponding to the fourth target data is 3 to 7, in comparison with a compression parameter "qp" of 4 to 8 in the existing data processing method, the fourth target data corresponds to a higher compression degree, and therefore, the amount of data sent for each update is smaller.

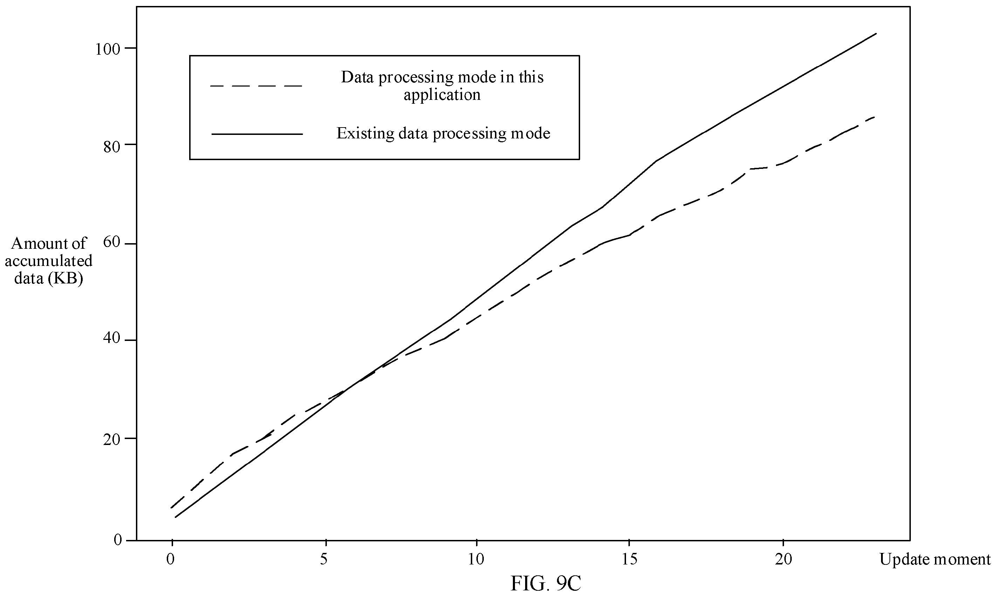

As shown in FIG. 9C, a horizontal coordinate indicates an update moment, and a vertical coordinate indicates an amount of accumulated data sent in KB. In this embodiment, the first target data is processed in a fine-grained manner based on the sampling point data, and an amount of data that needs to be uploaded increases in comparison with the embodiment shown in FIG. 8A to FIG. 8D. Therefore, a slope of the amount of accumulated data sent changes insignificantly. Until a last update moment, in comparison with the existing data processing method, the data processing method provided in this application can reduce the amount of accumulated data by about 17%.

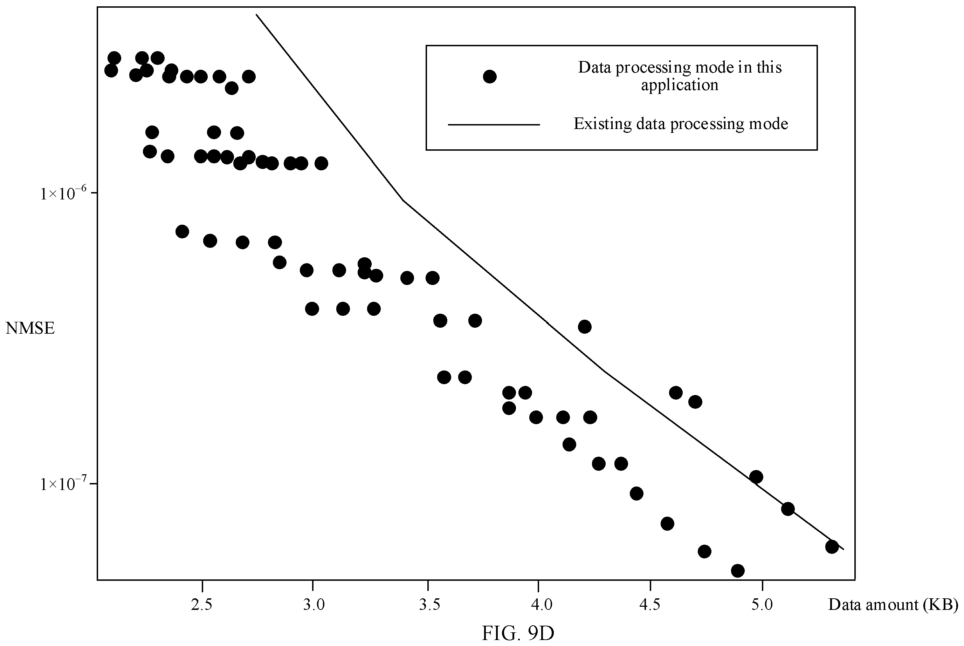

As shown FIG. 9D, a horizontal coordinate indicates an amount of sent data, and a vertical coordinate indicates an NMSE. It can be learned from the figure that when the NMSE has reconstruction performance of a magnitude of 10⁻⁷, in comparison with the existing data processing method, the data processing method provided in this application can reduce the data amount by 12% to 32%. Because first indication information delivered by the base station further includes the sampling point data, average downlink overheads required by the first indication information is 0.1224 KB, which accounts for about 3.5% of compressed uplink data, and accounts for about 3.2% of compressed uplink data in the existing data processing method in comparison with the existing data processing method.

It should be noted that, after confirming that an object in first space is the first target object, the base station may no longer deliver sampling point data of a first reconstructed object at subsequent update moments. For the first target data, the UE uses previously delivered sampling point data of the first reconstructed object, to determine the fourth target data in the first target data. In this way, downlink overheads required for sending the first indication information can be reduced. When the UE needs to send third compressed data, the UE may fuse third target data delivered by the base station and first target data at a current update moment, to obtain fused first target data, and determine the fourth target data based on the fused first target data.

It can be learned from the simulation in the foregoing embodiment that the data processing method provided in this application can reduce a communication data amount between the UE and the base station while ensuring reconstruction performance, thereby improving communication efficiency and reducing bandwidth load.

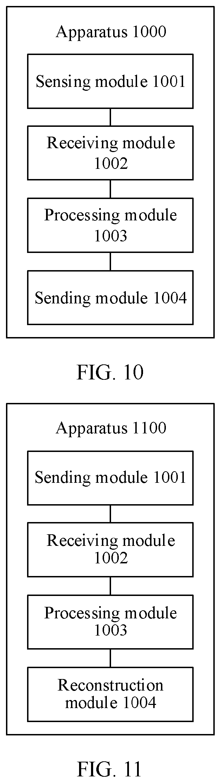

FIG. 10 is a diagram of a structure of a data processing apparatus according to an embodiment of this application. As shown in FIG. 10, the apparatus 1000 in this embodiment may include: a sensing module 1001, a receiving module 1002, a processing module 1003, and a sending module 1004. The apparatus 1000 may be configured to implement an operation implemented by the terminal device in the method in FIG. 2 or the methods in FIG. 4 to FIG. 6.

For example, the sensing module 1001 may be configured to obtain target sensing data.

The receiving module 1002 may be configured to receive first indication information from a network device, where the first indication information includes at least one piece of target data, the at least one piece of target data is in one-to-one correspondence with at least one reconstructed object included in reconstruction space, each of the at least one piece of target data corresponds pose data of a reconstructed object, and the pose data includes location data and/or posture data.

The processing module 1003 may be configured to compress first target data in the target sensing data in a first compression mode, to obtain first compressed data. The processing module 1003 may be further configured to compress second target data in the target sensing data in a second compression mode, to obtain second compressed data.

The sending module 1004 may be configured to send the first compressed data, the second compressed data, and first index information to the network device, where the first index information indicates that the first compressed data is in one-to-one correspondence with a first reconstructed object.

FIG. 11 is a diagram of a structure of a data processing apparatus according to another embodiment of this application. As shown in FIG. 11, the apparatus 1100 in this embodiment may include a sending module 1101, a receiving module 1102, a processing module 1103, and a reconstruction module 1104. The apparatus 1100 may be configured to implement an operation implemented by the network device in the method in FIG. 2 or the methods in FIG. 4 to FIG. 6.

For example, the sending module 1101 may send first indication information to a terminal device, where the first indication information includes at least one piece of target data, the at least one piece of target data is in one-to-one correspondence with at least one reconstructed object included in reconstruction space, each of the at least one piece of target data corresponds to pose data of a reconstructed object, and the pose data includes location data and/or posture data.

The receiving module 1102 may be configured to receive first compressed data, second compressed data, and first index information from the terminal device, where the first index information indicates that the first compressed data is in one-to-one correspondence with a first reconstructed object.

The processing module 1103 may be configured to determine first target data and second target data from a plurality of pieces of target data in target sensing data.

The reconstruction module 1104 may be configured to update the reconstruction space based on the first compressed data and the second compressed data.

It should be understood that the apparatus 1000 and the apparatus 1100 are embodied in a form of functional modules. The term "module" may be an application-specific integrated circuit (application-specific integrated circuit, ASIC), an electronic circuit, a processor (for example, a shared processor, a dedicated processor, or a group processor) configured to execute one or more software or firmware programs, a memory, a merged logic circuit, and/or another appropriate component that supports the described function.

The apparatus 1000 and the apparatus 1100 have functions of implementing corresponding procedures and/or steps in the foregoing method embodiments. The foregoing functions may be implemented by hardware, or may be implemented by hardware by executing corresponding software. The hardware or the software includes one or more modules corresponding to the foregoing functions.

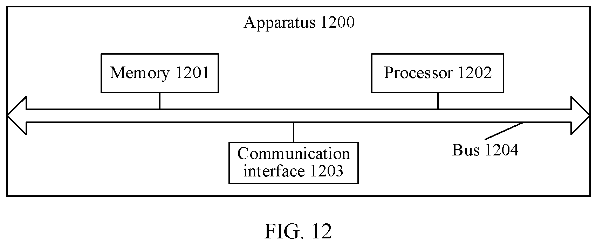

FIG. 12 is a diagram of a structure of a data processing apparatus according to still another embodiment of this application. The apparatus 1200 shown in FIG. 12 may be configured to perform the method performed by the terminal device or the network device in any one of the foregoing methods.

As shown in FIG. 12, the apparatus 1200 in this embodiment includes a memory 1201, a processor 1202, a communication interface 1203, and a bus 1204. The memory 1201, the processor 1202, and the communication interface 1203 are communicatively connected to each other through the bus 1204.

The memory 1201 may be a read-only memory (read-only memory, ROM), a static storage device, a dynamic storage device, or a random access memory (random access memory, RAM). The memory 1201 may store a program. When the program stored in the memory 1201 is executed by the processor 1202, the processor 1202 is configured to perform any one of the foregoing methods.

The processor 1202 may be a general-purpose central processing unit (central processing unit, CPU), a microprocessor, an application-specific integrated circuit, or one or more integrated circuits, and is configured to execute a related program.

The processor 1202 may alternatively be an integrated circuit chip and has a signal processing capability. During implementation, the related steps in embodiments of this application may be completed by using an integrated logic circuit of hardware in the processor 1202 or instructions in a form of software.

The processor 1202 may alternatively be a general-purpose processor, a digital signal processor (digital signal processing, DSP), an application-specific integrated circuit (ASIC), a field programmable gate array (field programmable gate array, FPGA) or another programmable logic device, a discrete gate or transistor logic device, or a discrete hardware component. The processor 1202 can implement or perform methods, the steps, logical block diagrams that are disclosed in embodiments of this application. The general-purpose processor may be a microprocessor, or the processor may be any regular processor or the like.

The steps in the methods disclosed with reference to embodiments of this application may be directly performed and completed by a hardware decoding processor, or may be performed and completed by a combination of hardware in the decoding processor and a software module. The software module may be located in a mature storage medium in the art, like a random access memory, a flash memory, a read-only memory, a programmable read-only memory, an electrically erasable programmable memory, or a register. The storage medium is located in the memory 1201. The processor 1202 reads information in the memory 1201, and completes, based on hardware of the processor 1202, functions that need to be performed by the units included in the apparatus in this application.

The communication interface 1203 may use, but not limited to, a transceiver apparatus of a transceiver type, to implement communication between the apparatus 1200 and another device or an apparatus.

The bus 1204 may include a path for transferring information between components (for example, the memory 1201, the processor 1202, and the communication interface 1203) of the apparatus 1200.

An embodiment of this application further provides a computer-readable storage medium. The computer-readable storage medium stores computer instructions. When executing the computer instructions, a processor implements the steps in the methods in the foregoing embodiments.

An embodiment of this application further provides a computer program product, including computer instructions. When the computer instructions are executed by a processor, the steps in the methods in the foregoing embodiments are implemented.

It should be noted that the modules or components shown in the foregoing embodiments may be configured as one or more integrated circuits, for example, one or more application-specific integrated circuits, one or more microprocessors, or one or more field programmable gate arrays, configured to implement the foregoing methods. For another example, when one of the foregoing modules is implemented in a form in which a processing element invokes program code, the processing element may be a general-purpose processor, for example, a central processing unit, or another processor, for example, a controller, that can invoke the program code. For another example, the modules may be integrated together and implemented in a form of a system-on-a-chip (system-on-a-chip, SoC).

All or a part of the foregoing embodiments may be implemented by software, hardware, firmware, a software module, or any combination thereof. When the software is used to implement embodiments, all or a part of embodiments may be implemented in a form of a computer program product. The computer program product includes one or more computer instructions. When the computer program instructions are loaded and executed on a computer, the procedures or functions according to embodiments of this application are all or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) mode. The computer-readable storage medium may be any usable medium accessible by the computer, or a data storage device, like a server or a data center, including one or more usable media. The usable medium may be a magnetic medium (for example, a floppy disk, a hard disk drive, or a magnetic tape), an optical medium (for example, a DVD), a semiconductor medium (for example, a solid-state drive Solid-State Drive (SSD)), or the like.

A person skilled in the art easily figures out another implementation solution of this application after considering this specification and practicing the present invention that is disclosed herein. This application is intended to cover any variation, function, or adaptive change of this application. These variations, functions, or adaptive changes comply with general principles of this application, and include common knowledge or a commonly used technical means in the technical field that is not disclosed in this application. The specification and embodiments are merely considered as examples, and the actual scope and spirit of this application are pointed out by the following claims.

It should be understood that this application is not limited to the accurate structures that are described in the foregoing and that are shown in the accompanying drawings, and various modifications and changes may be made without departing from the scope of this application. The scope of this application is limited only by the appended claims.

## Claims

1. A data processing method, applied to a terminal device, wherein the method comprises:
obtaining target sensing data, wherein the target sensing data is sensing data of a target object in first space in which the terminal device is located;
compressing first target data in the target sensing data in a first compression mode, to obtain first compressed data, wherein the first target data is sensing data of a first target object in the first space, and reconstruction space corresponding to the first space comprises a first reconstructed object corresponding to the first target object; and
sending the first compressed data and first index information to a network device, wherein the first index information indicates that the first compressed data corresponds to the first reconstructed object.

2. The method according to claim 1, wherein before the compressing the first target data in the target sensing data in the first compression mode, to obtain the first compressed data, the method further comprises:
receiving first indication information from the network device, wherein the first indication information is used to determine the first target data; and
determining the first target data from the target sensing data based on the first indication information, and obtaining the first index information based on the first indication information.

3. The method according to claim 1 or 2, wherein the method further comprises:
compressing second target data in the target sensing data in a second compression mode, to obtain second compressed data, wherein the second target data is sensing data of a second target object in the first space, and the reconstruction space comprises no second reconstructed object corresponding to the second target object; and
sending the second compressed data to the network device.

4. The method according to any one of claims 1 to 3, wherein the first compression mode comprises: determining pose data corresponding to the first target data as the first compressed data, wherein the pose data comprises location data and/or posture data.

5. The method according to any one of claims 1 to 3, wherein the first compression mode comprises: determining a difference between pose data corresponding to the first target data and first pose data as the first compressed data, wherein the pose data comprises location data and/or posture data, and the first pose data is pose data of the first reconstructed object in the reconstruction space.

6. The method according to claim 4 or 5, wherein the location data comprises geometric central point data and/or geometric vertex data, and the posture data comprises yaw angle data.

7. The method according to claim 2, wherein the first indication information comprises at least one piece of target data, the at least one piece of target data is in one-to-one correspondence with at least one reconstructed object comprised in the reconstruction space, each of the at least one piece of target data comprises pose data of a corresponding reconstructed object, and the pose data comprises location data and/or posture data; and
the determining the first target data from the target sensing data based on the first indication information comprises:
obtaining pose data corresponding to each piece of target data in the target sensing data, wherein a difference between a posture indicated by posture data corresponding to the first target data and a posture indicated by posture data in third target data in the at least one piece of target data is less than a posture difference threshold, and/or a distance between location data corresponding to the first target data and location data in the third target data is less than a first distance threshold, wherein the third target data corresponds to the first reconstructed object.

8. The method according to claim 7, wherein the third target data further comprises sampling point data of the first reconstructed object, and the sampling point data of the first reconstructed object indicates location data of each of at least one point on the first reconstructed object; and
the method further comprises:
determining a first neighboring distance between the first reconstructed object and the first target object based on the sampling point data comprised in the third target data, wherein the first neighboring distance indicates a shortest distance between the first reconstructed object and the first target object;
compressing fourth target data in a third compression mode, to obtain third compressed data, wherein the fourth target data is sensing data of a fourth target object in the first target object, the first neighboring distance corresponding to the fourth target object is greater than or equal to a second threshold, and a compression ratio of the third compression mode is higher than that of the second compression mode; and
sending the third compressed data to the network device.

9. The method according to claim 8, wherein that the sampling point data of the first reconstructed object indicates the location data of each of the at least one point on the first reconstructed object comprises:
the sampling point data of the first reconstructed object indicates location data of each of at least one point on a first outer surface of the first reconstructed object, and the first outer surface comprises at least one outer surface of the first reconstructed object; and
that the first neighboring distance indicates the shortest distance between the first reconstructed object and the first target object comprises:
the first neighboring distance indicates a shortest distance between the first outer surface of the first reconstructed object and a second outer surface of the first target object, and the second outer surface is an outer surface that is of the first target object and that corresponds to the first outer surface of the first reconstructed object.

10. The method according to claim 8 or 9, wherein before the receiving the first indication information from the network device, the method further comprises:
sending first request information to the network device, wherein the first request information is used to request sampling point data of a reconstructed object comprised in the reconstruction space, wherein
each piece of target data comprises sampling point data of the corresponding reconstructed object.

11. The method according to any one of claims 8 to 10, wherein the first indication information further indicates the second distance threshold.

12. The method according to claim 3, wherein the receiving the first indication information from the network device comprises:
sending pose data corresponding to each of a plurality of pieces of target data in the target sensing data to the network device, wherein the plurality of pieces of target data are in one-to-one correspondence with a plurality of target objects in the first space; and
receiving the first indication information from the network device, wherein the first indication information indicates the first target data and the second target data in the plurality of pieces of target data.

13. The method according to claim 12, wherein the first indication information further indicates to compress the first target data in the first compression mode, and the first indication information further indicates to compress the second target data in the second compression mode.

14. The method according to claim 12 or 13, wherein before the receiving the first indication information from the network device, the method further comprises:
sending second request information to the network device, wherein the second request information is used to request sampling point data of the first reconstructed object.

15. The method according to claim 1, wherein the first compression mode comprises: determining encoded residual data of the first target data and pose data corresponding to the first target data as the first compressed data, wherein the pose data comprises location data and/or posture data.

16. The method according to any one of claims 1 to 15, wherein the method further comprises:
sending third indication information to the network device, wherein the third indication information indicates to compress the first target data in the first compression mode and to compress the second target data in the second compression mode, and the third indication information further indicates a compression parameter of the first compression mode and a compression parameter of the second compression mode.

17. A data processing method, applied to a network device, wherein the method comprises:
receiving first compressed data from a terminal device, wherein the first compressed data is data obtained by processing first target data in a first compression mode, the first target data is sensing data of a first target object in first space, and reconstruction space corresponding to the first space comprises a first reconstructed object corresponding to the first target object; and
updating the reconstruction space based on the first compressed data.

18. The method according to claim 17, wherein the method further comprises:
receiving second compressed data from the terminal device, wherein the second compressed data is data obtained through second compression processing on second target data, the second target data is sensing data of a second target object in the first space, and the reconstruction space comprises no second reconstructed object corresponding to the second target object; and
updating the reconstruction space based on the second compressed data.

19. The method according to claim 17 or 18, wherein the first compression mode comprises: determining pose data corresponding to the first target data as the first compressed data, wherein the pose data comprises location data and/or posture data.

20. The method according to claim 19, wherein the updating the reconstruction space based on the first compressed data comprises:
updating location data of each point on the first reconstructed object in the reconstruction space based on a difference between the pose data corresponding to the first target data and first pose data, wherein the first pose data is pose data of the first reconstructed object.

21. The method according to any one of claims 17 to 20, wherein before the receiving the first compressed data from the terminal device, the method further comprises:
sending first indication information to the terminal device, wherein the first indication information is used to determine the first target data.

22. The method according to claim 21, wherein the first indication information comprises at least one piece of target data, the at least one piece of target data is in one-to-one correspondence with at least one reconstructed object comprised in the reconstruction space, each of the at least one piece of target data comprises pose data of a corresponding reconstructed object, and the pose data comprises location data and/or posture data.

23. The method according to claim 22, wherein third target data in the at least one piece of target data further comprises sampling point data of the first reconstructed object, the sampling point data of the first reconstructed object indicates location data of each of at least one point on the first reconstructed object, and the third target data corresponds to the first reconstructed object; and
the method further comprises:
receiving third compressed data from the terminal device, wherein the third compressed data is data obtained by processing fourth target data in a third compression mode, the fourth target data is sensing data of a fourth target object in the first target object, the first neighboring distance corresponding to the fourth target object is greater than or equal to a second threshold, and a compression ratio of the third compression mode is higher than that of the second compression mode.

24. The method according to claim 23, wherein that the sampling point data of the first reconstructed object indicates the location data of each of the at least one point on the first reconstructed object comprises:
the sampling point data of the first reconstructed object indicates location data of each of at least one point on a first outer surface of the first reconstructed object, and the first outer surface comprises at least one outer surface of the first reconstructed object; and
that the first neighboring distance indicates a shortest distance between the first reconstructed object and the first target object comprises:
the first neighboring distance indicates a shortest distance between a first outer surface of the first target object and a second outer surface of the first reconstructed object, and the second outer surface is an outer surface that is of the first reconstructed object and that corresponds to the first outer surface of the first target object.

25. The method according to claim 21, wherein the sending the first indication information to the terminal device comprises:
receiving pose data corresponding to each of a plurality of pieces of target data in the target sensing data of the terminal device, wherein the plurality of pieces of target data are in one-to-one correspondence with a plurality of target objects in the first space;
determining the first target data and the second target data from the plurality of pieces of target data, wherein a difference between a posture indicated by the posture data corresponding to the first target data and a posture indicated by posture data in third target data in the at least one piece of target data is less than a posture difference threshold, and/or a distance between the location data corresponding to the first target data and location data in the third target data is less than the first distance threshold, wherein the third target data corresponds to the first reconstructed object; and
sending the first indication information to the terminal device, wherein the first indication information indicates the first target data and the second target data in the plurality of pieces of target data.

26. The method according to claim 25, wherein the first indication information further indicates to compress the first target data in the first compression mode, and the first indication information further indicates to compress the second target data in the second compression mode.

27. The method according to claim 17 or 18, wherein the first compression mode comprises: determining encoded residual data of the first target data and pose data corresponding to the first target data as the first compressed data, wherein the pose data comprises location data and/or posture data.

28. A data processing apparatus, comprising a processor and a memory, wherein
the memory stores computer-executable instructions; and
the processor executes the computer-executable instructions stored in the memory, to cause the data processing apparatus to perform the data processing method according to any one of claims 1 to 16 or any one of claims 17 to 27.

29. A computer-readable storage medium, wherein the computer-readable storage medium stores computer-executable instructions, and when the computer-executable instructions are executed by a processor, the data processing method according to any one of claims 1 to 16 or any one of claims 17 to 27 is implemented.
